(19)

(11) **EP 1 751 788 B1**

(12) **EUROPEAN PATENT SPECIFICATION**

(45) Date of publication and mention of the grant of the patent:
**28.11.2018 Bulletin 2018/48**

(21) Application number: **04774545.0**

(22) Date of filing: **09.09.2004**

(51) Int Cl.:
***H01L 21/762*** *(2006.01)* ***C30B 29/06*** *(2006.01)*

(86) International application number:
**PCT/KR2004/002286**

(87) International publication number:
**WO 2005/106933 (10.11.2005 Gazette 2005/45)**

(54) **FLEXIBLE SINGLE-CRYSTAL FILM AND METHOD OF MANUFACTURING THE SAME**

FLEXIBLER EINKRISTALLFILM UND HERSTELLUNGSVERFAHREN DAFÜR

FILM MONOCRISTALLIN SOUPLE ET PROCEDE DE FABRICATION

(84) Designated Contracting States:
**AT BE BG CH CY CZ DE DK EE ES FI FR GB GR HU IE IT LI LU MC NL PL PT RO SE SI SK TR**

(30) Priority: **28.04.2004 US 833050**

(43) Date of publication of application:
**14.02.2007 Bulletin 2007/07**

(73) Proprietor: **IUCF-HYU (INDUSTRY-UNIVERSITY COOPERATION FOUNDATION HANYANG UNIVERSITY)**
**Seoul 133-791 (KR)**

(72) Inventors:
- **PARK, Jong-Wan**
  **Namyangju 472-962 (KR)**
- **PARK, Jae-Gun**
  **Sungnam 463-500 (KR)**

(74) Representative: **Michalski Hüttermann & Partner Patentanwälte mbB**
**Speditionstraße 21**
**40221 Düsseldorf (DE)**

(56) References cited:
**EP-A- 0 849 788** **EP-A- 1 039 513**
**EP-A- 1 069 602** **JP-A- 03 250 666**
**JP-A- 05 275 329** **JP-A- 2001 185 528**
**JP-A- 2003 017 726** **JP-A- 2003 218 330**
**KR-A- 20040 014 719** **KR-A- 20040 093 949**
**KR-A- 20040 100 469** **KR-Y1- 200 174 717**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 1 751 788 B1

Printed by Jouve, 75001 PARIS (FR)

## Description

Technical Field

The present invention relates to a flexible single-crystal film and a method of manufacturing the same from a single-crystal wafer. That is, the present invention can manufacture a silicon-on-insulator (SOI) wafer comprising a base wafer, one or more buried insulator layers, and a single-crystal layer into a flexible single-crystal film with a desired thickness by employing various wafer thinning techniques.

The present invention also relates to manufacturing a flexible film on which various electronic devices are manufactured from a single-crystal semiconductor wafer. That is, the present invention can manufacture a flexible single-crystal film with desired thickness having various electronic devices by employing a variety of wafer thinning techniques once the electronic devices of desired characteristics on the SOI wafer, comprising the base wafer, buried insulator layers, and single-crystal layer, are constructed.

Background Art

At present, electronic apparatuses have drastically improved in design, shifting from lightweight and compact designs to overall and enhanced flexibility. With the growth of mobile wireless Internet and electronic commercial transactions, demand has particularly increased for new flexible displays. As such, the present invention can be applied to foldable radiotelephones, PDAs, flexible electronic books, electronic newspapers, and the like commercially. The present invention can also be applied to electronic blackboards, displays for CAD/CAM, electric signs, and electric billboards.

In spite of the demand for such flexible electronic apparatuses, the major reason for the delay in developing a flexible electronic apparatus is that there is no substrate material from which electronic devices of the desired characteristics are stably manufactured. For example, in the case of a flexible LCD display, the flexible substrate is required in order to stably manufacture a TFT (thin film transistor) array. Up to now, there have been methods for manufacturing the TFT array by forming amorphous silicon or poly-silicon for manufacturing electronic devices on a flexible, transparent plastic substrate under low temperature or by transferring poly-silicon TFT array manufactured on a glass substrate into flexible plastic substrate, and for manufacturing organic TFT using a smooth and organic semiconductor.

However, in the case of electronic devices using a plastic substrate or a plastic substrate after manufacturing electronic devices on a glass substrate, deformation can occur due to different thermal expansion coefficients between organic substrate and inorganic electronic devices. Organic semiconductors, in fact, can cause the electronic devices to lack the desired characteristics.

Known from EP 0 849 788 A2 is a method for producing a semiconductor article that can suitably be used for producing a semiconductor device. According to this method, a porous ion implantation layer is formed in the interior of a first single crystal Si substrate. A nonporous layer is formed preliminarily on the surface thereof. Prior to the ion implantation, a protection film, such as a $SiO_2$ film, is preferably formed on the main surface layer to prevent roughening of the surface. Onto the main surface of the first Si substrate, a flexible adherent film or a flexible film with an adhesive is bonded. Thereafter, the flexible film is peeled from the first single crystal Si substrate to separate the first substrate side and the film side at the porous ion implantation layer. Thus the porous layer is separated from substrate. Correspondingly, an article is disclosed comprising a porous ion implantation layer being formed in the interior of a single crystal Si substrate, wherein a protection film may be formed on the surface layer. By peeling off a flexible film comprising a porous Si-layer as well as the ion implantation layer from the article by means of an adherent film, a flexible film comprising an ion implantation layer, and a single crystal porous Si-layer is formed. Additionally, the film may comprise several layers comprising e.g. an electrode on which a TEFZEL (modified ETFE (ethylene-tetrafluoroethylene))-film is provided.

Known from EP 1 069 602 A2 is a method of producing thin-film single-crystal devices, especially for solar cell modules. In this method, ion implantation may be used to cleave a respective layer. In detail, an implantation of hydrogen is described.The respective film comprises several layers, e.g. a substrate layer and two different single crystal layers. Furthermore, the film may comprise a grid electrode which may be covered by a 0.2 mm thick PET film.

Disclosure of Invention

Technical Problem

It is an object of the present invention to manufacture a flexible single-crystal film, which enables the electronic devices of desired characteristics to be manufactured and to be flexible enough, to solve the above-mentioned problems, specifically, by using a single-crystal wafer.

Another object of the present invention is to stably manufacture a flexible film wherein various desired electronic devices are manufactured on the single-crystal layer by a simple technique in order to embody the desired characteristics.

A further object of the present invention is to improve productivity and reduce the cost of production by simplifying the manufacturing process of the flexible single- crystal film.

The above objects can be accomplished by providing a flexible film comprising a single-crystal layer which is manufactured from a single-crystal wafer. The flexible film comprises a flexible single-crystal layer manufactured from a single-crystal wafer; a device layer formed on a surface of the single-crystal layer; one or more protection layers on the device layer; and one or more flexible insulator layers on the other surface of said single crystal layer .

Technical Solution

The present invention is defined by the dependent claims.

The flexible film according to the invention comprises a single-crystal layer which is manufactured from a single-crystal wafer; an electronic device formed on a surface of the single-crystal layer; one or more protection layers on the electronic device; and one or more flexible insulator layers on the other surface of said single-crystal layer wherein the single-crystal layer has a thickness of several ten nanometers to several ten micrometers and is flexible.

The flexible single-crystal film according to the present invention may be a pure, defect free, flexible single-crystal film manufactured from a SOI wafer, which comprises a single-crystal layer manufactured from a single-crystal wafer; a device layer formed on a surface of the single-crystal layer; one or more protection layers on the device layer; and one or more flexible insulator layers on the other surface of said single crystal layer, by removing the base wafer through a variety of thinning techniques, wherein the flexible single-crystal film according to the present invention enables the thickness of the single-crystal layer to be controlled, for example, within the range from several ten nanometers up to several ten micrometers, when manufacturing the SOI wafer by the SOI manufacturing process. The single- crystal layer of the present invention may be a single-crystal layer of silicon or a compound semiconductor, such as gallium arsenide.

The flexible single-crystal film according to the present invention comprises a flexible single-crystal layer manufactured from a single-crystal wafer and one or more device layer formed on a surface of the single-crystal layer, wherein various electronic devices are manufactured on the flexible single-crystal layer.

The flexible single-crystal film, on which the various electronic devices are manufactured according to the present invention, may be manufactured by removing the base wafer of the SOI wafer. This can be achieved by manufacturing the electronic devices of desired characteristics on the single-crystal layer of the SOI wafer using a general semiconductor manufacturing process.

The method according to the present invention comprises the steps of: providing a SOI wafer comprising a base wafer, one or more buried insulator layers on the base wafer, and a single-crystal layer on said one or more buried insulator layers; forming one or more protection layers on said single-crystal layer; removing said base wafer; and removing one or more of the insulator layers, wherein said step of providing the SOI wafer comprises the steps of: providing the base wafer and a bonding wafer; forming said one or more buried insulator layers on said base wafer; implanting hydrogen ions into said bonding wafer; bonding said base wafer and said bonding wafer; cleaving a region where hydrogen ions are implanted in said bonding wafer to cleave said bonding wafer; and etching the cleaved surface of said bonding wafer on said base wafer to manufacture the SOI wafer wherein the single-crystal layer is formed on the buried insulator layers of the base wafer wherein said single-crystal layer is formed from said bonding wafer stayed on said insulator layers, and has a thickness of several ten nanometers to several ten micrometers and is flexible.

The method for manufacturing a flexible film comprises the steps of (i) providing a SOI wafer comprising a base wafer, one or more buried insulator layers on the base wafer, and a single-crystal layer on the one or more buried insulator layers, (ii) forming one or more protection layers on the single-crystal layer, (iii) removing the base wafer, and (iv) removing one or more of the insulator layers. The step of providing the SOI wafer comprises the steps of (i) providing the base wafer and a bonding wafer, (ii) forming one or more buried insulator layers on the base wafer, (iii) implanting hydrogen ions into the bonding wafer, (iv) bonding the base wafer and the bonding wafer, (v) cleaving the bonding wafer, and (vi) etching the cleaved surface of the bonding wafer to manufacture the SOI wafer wherein the single-crystal layer is formed on the buried insulator layers of the base wafer. The step of removing the base wafer may comprise the step of removing the entire base wafer by wet etching it with KOH. The base wafer may removed by grinding the base wafer to a desired thickness, and the remaining base wafer after grinding may be removed by wet etching it with KOH. In addition, the step of forming the one or more protective insulator layers on the single-crystal layer may comprise the steps of forming an oxide film on the single-crystal layer, and forming a nitride film on the oxide film. The step of removing one or more of the insulator layers may comprise the step of removing all of the insulator layers by wet etching them with HF.

A method for manufacturing a flexible film according to the present invention using a jig comprises the steps of (i) providing a SOI wafer comprising a base wafer, one or more buried insulator layers on the base wafer, and a single-crystal layer on the one or more buried insulator layers, (ii) holding the SOI wafer with a jig to expose the lower surface of the base wafer, and (iii) removing the base wafer by etching it. When the SOI wafer is held with the jig, specifically, the edges, the entire lower surface of the base wafer is exposed and etched. The base wafer may be etched after holding the peripheral portion of the SOI wafer with the jig to expose a portion of the lower surface of the base wafer. The base wafer may be removed by cutting the peripheral portion which is held by the jig. The base wafer may be removed by wet etching it with KOH, and one or more of the insulator layers may be removed by wet etching them with HF.

A method for manufacturing a flexible film by grinding according to the present invention using the jig comprises the steps of (i) providing a SOI wafer comprising a base wafer, one or more buried insulator layers on the base wafer, and a single-crystal layer on the one or more buried insulator layers; (ii) bonding a supporting wafer to the single-crystal layer of the SOI wafer; and (iii) removing the base wafer and the supporting wafer. The base wafer may be removed by grinding and etching it. One or more protective insulator layers may be formed on the single-crystal layer before bonding a supporting wafer to said single-crystal layer of said SOI wafer. Also, the method for manufacturing a flexible film by grinding and using the jig according to the present invention comprises the steps of (i) providing a SOI wafer comprising a base wafer, one or more buried insulator layers on the base wafer, and a single-crystal layer on the one or more buried insulator layers; (ii) grinding the base wafer to a predetermined thickness; (iii) holding the SOI wafer with a jig to expose the lower surface of the remaining base wafer after grinding; (iv) and removing the remaining base wafer by wet etching it. One or more protective insulator layers may be formed on the single-crystal layer before grinding the base wafer. The one or more buried insulator layers and/or the one or more protective insulator layers may be removed after removing the base wafer.

The method for manufacturing a flexible film on which electronic devices are manufactured according to the present invention comprises the steps of (i) providing a SOI wafer comprising a base wafer, one or more buried insulator layers on the base wafer, and a single-crystal layer on the one or more buried insulator layers, (ii) forming one or more device layers by manufacturing electronic devices on the single-crystal layer, (iii) forming a protective film for the devices on the device layer, and (iv) removing the base wafer. The base wafer may be removed by the various methods described above.

The thickness of the single-crystal layer can be controlled by controlling the depth of the cleaving and etching the cleaved surface of the bonding wafer. For the method of manufacturing a bonded SOI wafer, please refer to U.S. Patent Application Serial No. US 10/391,297.

A jig usable in etching a wafer comprises a lower plate; an upper plate having one or more through holes; and fixtures for joining the lower and upper plates together, wherein the wafer is positioned between the lower plate and the upper plate, the portion of the wafer to be etched is exposed through the one or more through holes, the wafer and the one or more through holes are sealed, and an etching solution is supplied through the one or more through holes. The upper plate is provided with a bath for containing the etching solution, and the bath is communicated with the one or more through holes. A heater and a thermometer are provided in the bath.

Description of Drawings

Fig. 1 shows a flow chart for manufacturing a flexible film according to Embodiment 1 of the present invention.

Fig. 2 shows views of the manufacturing process of a flexible film according to Embodiment 1 of the present invention.

Fig. 3 shows views of a flexible film manufactured according to Embodiment 1 of the present invention.

Fig. 4 shows views illustrating the method of measuring the flexibility of a flexible film.

Fig. 5 shows a flow chart for manufacturing a flexible film according to Embodiment 2.

Fig. 6 shows views of the manufacturing process of a flexible film according to Embodiment 2.

Fig. 7 shows a perspective view of a jig.

Fig. 8 shows views illustrating the manufacturing process of a flexible film by etching the entire surface of a base wafer, according to Embodiment 3.

Fig. 9 shows views illustrating the manufacturing process of a flexible film by etching a portion of the surface of the base wafer, according to Embodiment 3.

Fig. 10 shows a flow chart for manufacturing a flexible film according to Embodiment 4.

Fig. 11 to 13 show views of the manufacturing processes of a flexible film according to Embodiment 4.

Fig. 14 shows a flow chart for manufacturing a flexible film according to Embodiment 5.

Fig. 15 and 16 show views of the manufacturing process of a flexible film according to Embodiment 5.

Fig. 17 shows views of the manufacturing process of a flexible film according to Embodiment 6.

Fig. 18 shows views of a flexible film manufactured according to Embodiment 6.

Best Mode

The process for manufacturing the flexible film from a single-crystal according to the present invention will now be explained in detail.

(Embodiment 1)

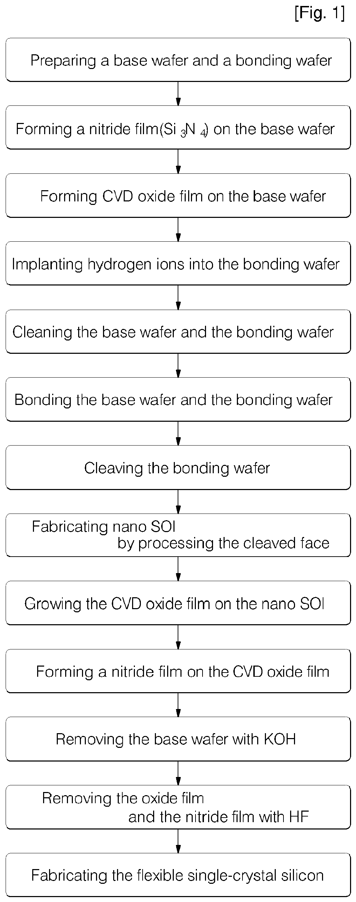

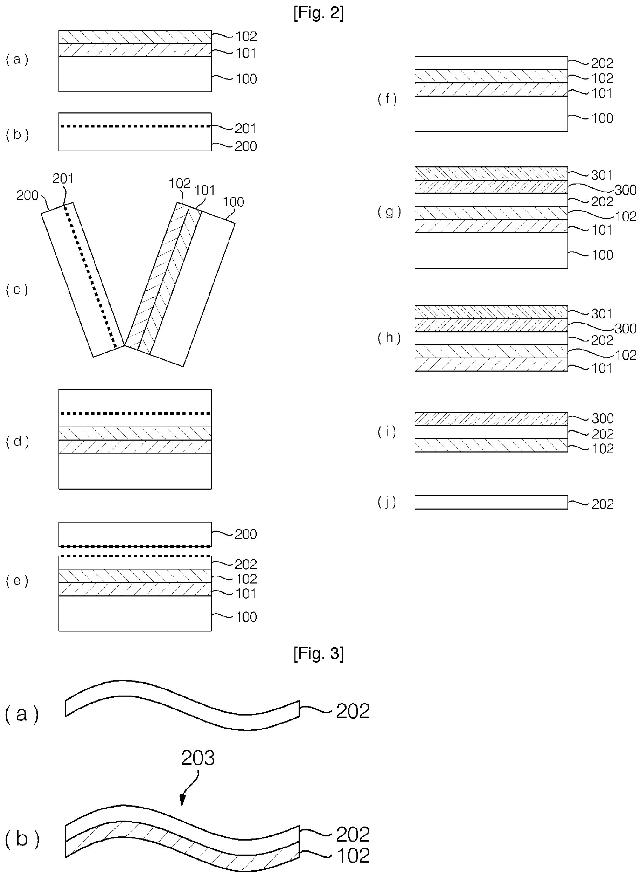

Referring to Fig. 1 and 2, the manufacturing process of the flexible single-crystal film according to the present invention is as follows.

A base wafer 100 and a bonding wafer 200 are provided as a bare silicon wafer. As shown in Fig. 2(a), such buried insulator layers as silicon nitride film ($Si_3N_4$) 101 and 3 4 silicon oxide film 102 are formed on a surface of the base wafer with uniform thickness. The silicon oxide film 102 is formed on the silicon nitride film 101. The silicon oxide film 102 may be formed by using chemical vapor deposition. As shown in Fig. 2(b), the bonding wafer 200 is formed with an impurity ion implantation portion 201 by implanting impurity ions into the predetermined depth of the surface thereof. At this time, impurities such as hydrogen ions are implanted into the surface of a wafer by a low voltage ion implantation method, causing a projection range distance (Rp) of the implanted hydrogen ions formed near the surface of the bonding wafer, for example, in the range of 100 to 1000 nm.

The base wafer 100, on which the buried insulator layers are formed as above, and the bonding wafer 200, into the surface of which hydrogen ions are implanted, are cleaned, and then, these wafers 100, 200 are bonded to each other as shown in Fig. 2(c). At this time, the wafers 100, 200 are cleaned under hydrophilic condition in order to improve the bonding force. The wafers 100, 200 are bonded vertically, as shown in Fig. 2(c), immediately after cleaning. For vertical bonding, the base wafer 100 and the bonding wafer 200 are placed in front of each other and connected at one end. As shown in Fig. 2(d), two wafers are manufactured with one wafer overlapping the other.

As described above, by heat-treating the bonded wafers under low temperature, the impurity ion implantation portion of the bonding wafer is cleaved as shown in Fig. 2(e). A single-crystal layer 202 of silicon is manufactured by processing the cleaved surface to the desired thickness by etching, CMP (chemical mechanical polishing), and the like (see Fig. 2(f)). The thickness of the single-crystal layer of silicon can be controlled according to need.

As shown in Fig. 2(g), protective insulator layers 300, 301 are formed on the single-crystal layer 202 manufactured on the base wafer 100, as described above. The protective insulator layers, which protect the single-crystal layer of silicon from being etched when the base wafer is removed by wet etching, includes an oxide film 300 and a nitride film 301 thereon.

After the protective insulator layers 300, 301 are formed on the single-crystal layer of silicon, the base wafer 100 is removed by wet etching it with KOH solution. The etching condition can be adjusted by controlling the etching temperature, the concentration of the etching solution, and the like.

Once removing the base wafer as described above, the insulator layers are left on the upper and lower surfaces of the single-crystal layer of silicon as shown in Fig. 2(h) so that the single-crystal layer and insulator layers become thin and flexible. The single-crystal layer of silicon is left alone by removing all of the buried and protective insulator layers by wet etching the films with HF solution, so that the pure flexible single-crystal film of silicon is obtained, as shown in Fig. 2(j). The flexible film, including the buried or protective insulator layers and the single-crystal layer of silicon, is also obtained by etching and removing the buried insulator layers or the protective insulator layers on the single-crystal layer of silicon.

Since it is possible to control the thickness of the flexible film from several ten nanometers up to several ten micrometers, the pure single-crystal film 202 of silicon having excellent flexibility and transparent property as in Fig. 3(a) and the flexible film 203 including the buried insulator layer 102 and the single-crystal layer 202 of silicon in Fig. 3(b), are applicable to a variety of fields. Also, the buried insulator layer 102 of the flexible film 203 protects the single-crystal layer 202 of silicon during handling.

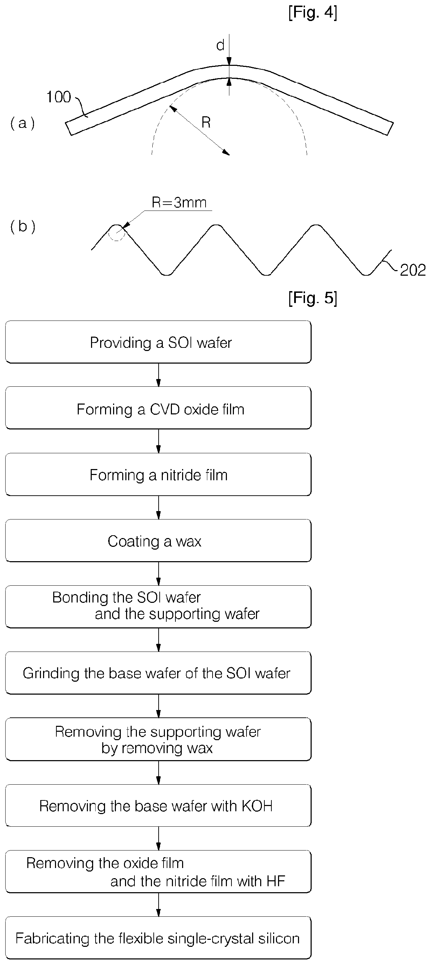

Theoretical flexibility of the single-crystal film of silicon, the radius of curvature, at which the single-crystal film of silicon is fractured when bent, can be calculated. As shown in Fig. 4(a), the stress when the silicon wafer with a thickness of d is bent to the radius of curvature of R, can be calculated as follows:

$$\sigma = (d/2R)E\ (< \sigma_y \text{ and } < \sigma_f)$$

where, $\sigma$ is stress, d is thickness, R is the radius of curvature, E is Young's modulus, $\sigma_y$ is yield stress, and $\sigma_f$ is fracture stress.

In general, E is 190 GPa, $\sigma_y$ is 6.9 GPa, and $\sigma_f$ is 2.8 GPa. Hence, the theoretical fracture curvature-radius of the single-crystal film of silicon of e.g. 5 $\mu$ m in thickness is estimated to be 0.17 mm. It was actually confirmed that the silicon film of 5 $\mu$ m in thickness according to the present invention can be bent without fracture at least at the radius of curvature of less than 3 mm (see Hg. 4(b)). Therefore, it is noted that the flexible single-crystal film of silicon according to the present invention can possess the desired flexibility. The flexible single-crystal film according to the following embodiments of the present invention also meets with the same results.

(Embodiment 2)

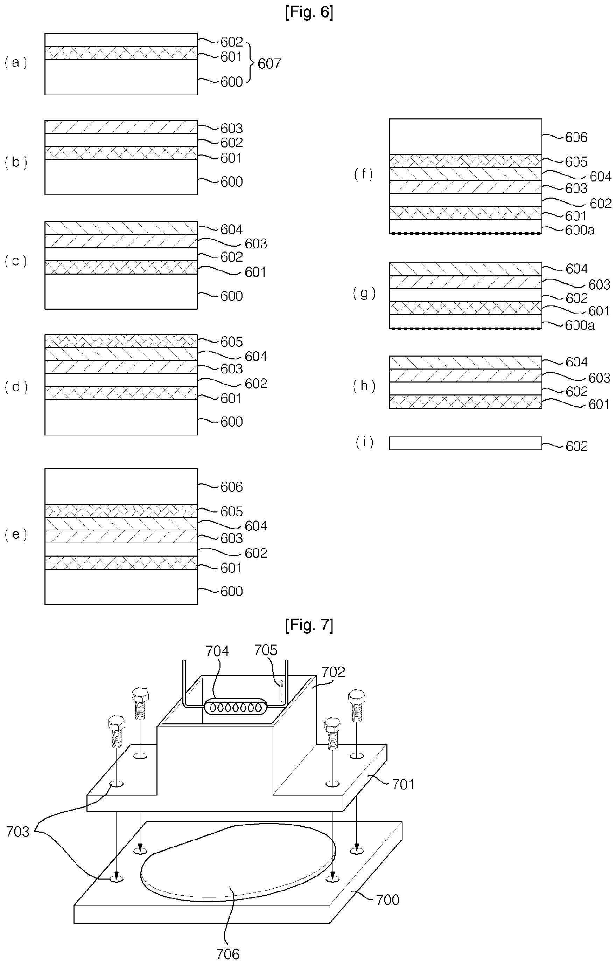

Referring to Figs. 5 and 6, a further manufacturing process of the flexible single-crystal film by grinding is as follows.

As shown in Fig. 6(a), a SOI wafer comprising a base wafer 600, a buried insulator layer 601 formed on the base wafer 600, and a single-crystal layer 602 of silicon formed on the buried insulator layer 601 is provided. The SOI wafer may be manufactured from a SOI wafer by bonding or a SIMOX (separation by implanted oxygen) wafer, or may be commercially available. Thick insulator layers are used. The thickness of the single-crystal layer is adjusted according to applications.

Protective insulator layers such as an oxide film 603 and a nitride film 604, which protect the single-crystal layer of silicon when a base wafer is removed, are formed on the SOI wafer, prepared as above. The oxide film 603 is formed, and then the nitride film 604 is formed on the oxide film 603 (Fig. 6 (c)).

After a bonding agent such as wax 605 is coated on the protective insulator layer, formed as above (Fig. 6(d)), a supporting wafer 606 is bonded thereon (Fig. 6(e)). The wax which is soluble in water may be selected. The supporting wafer is bonded by vertical or horizontal bonding. In the post grinding process, the supporting wafer protects the SOI wafer and facilitates the process. Since the SOI wafer becomes thin as it is ground, it may be fractured in a chuck of a grinding machine. Therefore, if the SOI wafer with the supporting wafer bonded is ground, the wafer is safely held in the chuck, though thinning the SOI wafer.

With the supporting wafer 606 bonded, as shown in Fig. 6(f), the base wafer 600 is ground to the desired thickness. The thickness can be desirously adjusted in grinding, for example from 50$\mu$m to 200$\mu$m. The supporting wafer 606 may be not used if the thickness of the remaining base wafer after grinding is thick.

After grinding the base wafer 600, the supporting wafer 606 is removed by dissolving the wax with aqueous solutions or a chemical agent (Fig. 6(g)).

After removing the supporting wafer 606, the remaining base wafer 600a after grinding is removed by wet etching it with a KOH solution (Fig. 6(h)).

As shown in Fig. 6(h), the insulator layers 604, 603, 601 are left on the upper and lower surfaces of the single-crystal layer 602 of silicon after the base wafer is removed, the thickness of the single-crystal layer and the insulator layers become thin enough so that the desired flexibility can be obtained. By removing all of the insulator layers on the upper and lower surfaces of the single-crystal layer of silicon by wet etching the films with HF solution, as shown in Fig. 6(i), the pure flexible single-crystal film is obtained. Also, if the buried insulator layer or the protective insulator layers on the single-crystal layer of silicon are removed by etching, the flexible film including the insulator layer(s) and the single-crystal layer of silicon is obtained.

If the flexible film is manufactured by such a method, the etching time can be significantly reduced. Since the base wafer is ground to the desired thickness, an etching flatness is desirable. Also, the flexible single-crystal film is easily manufactured from a commercially available SOI wafer by using a thinning method.

(Embodiment 3)

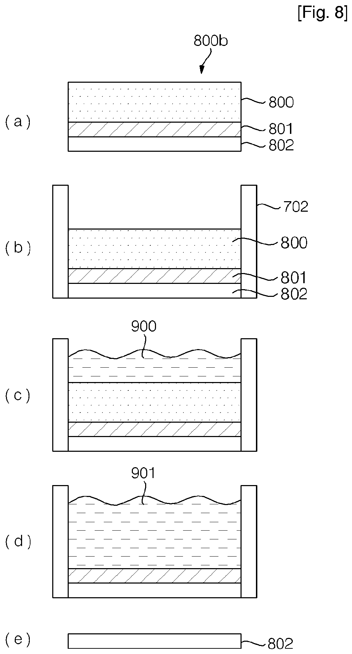

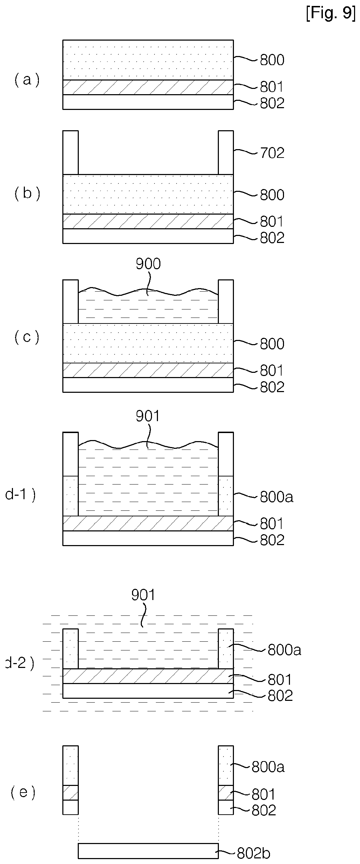

Referring to Figs. 8 and 9, a further manufacturing process of the flexible single-crystal film using a jig is as set forth below.

First, the jig will be explained. As shown in Fig. 7, the jig comprises a lower plate 700 and an upper plate 701 wherein a wafer 706 is installed therebetween. These plates 700, 701 are made from material that is stable against chemical agents, such as, Teflon. The upper plate 701 is provided with a bath 702 for containing chemical solution when the upper and lower plates are joined together. The bottom of the bath 702 includes a through hole through which the portion of the wafer to be etched is exposed. The wafer and the through hole are sealed. The through hole of the bath 702 can be manufactured into a tube or other various shapes such as rectangular and circular cylinders. Fixtures 703 are provided for joining the lower and upper plates together.

Using such a jig, a single side of the wafer can be removed by wet etching. The wafer 706 is positioned on the lower plate 700 wherein the wafer surface to be removed by etching faces the upper plate 701. After the lower and upper plates are joined and fixed to each other, the wafer surface is removed by supplying an etching solution into the bath 702. According to the etching condition, a heater 704 and thermometer 705 coated with Teflon may be provided in the bath 702 to control the etching temperature.

Referring to Fig. 8, the removal process by etching an entire surface of the base wafer using the jig is as follows.

The SOI wafer comprising a base wafer 800, an insulator layer 801 formed on the base wafer, and a single-crystal layer 802 of silicon formed on the insulator layer is prepared, wherein the surface of the SOI wafer to be removed by etching laces upward. As shown in Fig. 8(b), the edges of the SOI wafer is held with the jig so that the entire surface of the base wafer to be removed by etching is exposed to the bath of the upper plate.

A KOH solution 900 is supplied onto the exposed surface of the base wafer so that the base wafer is removed by etching as shown in Fig. 8(c). By draining the KOH solution 900 from and supplying a HF solution 901 onto the exposed surface, the insulator layer 801 is removed by etching so that the pure, flexible, single-crystal film of silicon is obtained (Fig. 8(c)). The removal of the insulator layer with the HF solution may be performed by dipping the entire SOI wafer without the jig in the HF solution.

By etching only with the KOH in the steps described above, the flexible film including the insulator layer and the single-crystal layer of silicon can be obtained.

Referring to Fig. 9, the removal process by etching a portion of the base wafer using the jig will be explained in more detail as below.

As shown in Fig. 9(a), the SOI wafer comprising the base wafer 800, the insulator layer 801 formed on the base wafer 800, and the single-crystal layer 802 of silicon formed on the insulator layer is prepared. The jig is positioned and pressed on the peripheral portion of the backside of the SOI wafer so that a portion of the surface to be removed by etching is exposed (see Fig. 9(b)).

The KOH solution 900 is supplied onto the exposed surface of the base wafer so that the base wafer is removed by etching as shown in Fig. 9(c). By draining the KOH solution from and supplying the HF solution onto the exposed surface, the insulator layer is removed by etching (see Fig. 9(d-1)). That is, the exposed surface of the base wafer is removed by etching, and the insulator layer functions as an etching protective layer. The removal of the insulator layer with the HF solution may be performed by dipping the entire SOI wafer without the jig in the HF solution (see Fig. 9(d-2)).

The pure, flexible single-crystal film of silicon is obtained by cutting the peripheral portion of the base wafer, not removed by etching (see Fig. 9(e)).

Also, by etching only with the KOH in the steps described above and cutting the peripheral portion of the base wafer, the flexible film including the insulator layer and the single-crystal layer of silicon can be obtained.

The flexible single-crystal film can be easily manufactured by etching and removing only one surface of the wafer by using the jig. That is, the processing steps can be reduced by etching the base wafer using the jig without additional processing. An unnecessary peripheral of a wafer can also be easily removed. The flexible film of the desired shape can be manufactured by changing the shape of the bath of the upper plate. That is, by etching a circular wafer, of which the peripheral portion is held with the jig having a rectangular cylinder-shaped bath for containing a chemical agent and by cutting the peripheral portion, a rectangular, flexible single-crystal film can be obtained.

(Embodiment 4)

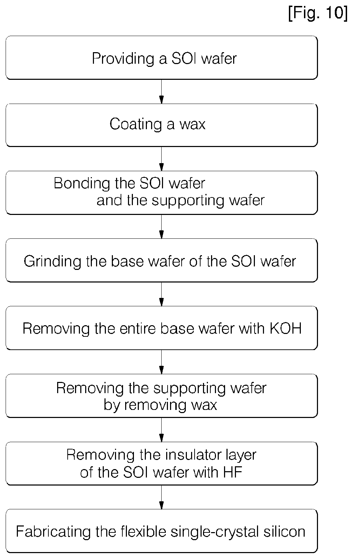

Referring to Figs. 10 to 13, a further manufacturing process of the flexible single-crystal film by grinding using a jig is as set forth below.

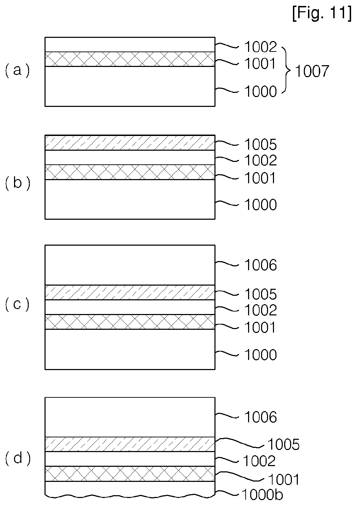

As shown in Fig. 11(a), a SOI wafer comprising a base wafer 1000, a buried insulator layer 1001 formed on the base wafer 1000, and a single-crystal layer 1002 of silicon formed on the buried insulator layer 1001 is provided. The thickness of the single-crystal layer is adjusted according to applications.

After a bonding the wax 1005 is coated on the SOI wafer provided as above (Fig. 11(b)), a supporting wafer 1006 is bonded thereon (Fig. 11(c)). The wax which is soluble in water may be selected. The supporting wafer 1006 is bonded by vertical or horizontal bonding. In the post grinding process, the supporting wafer protects the SOI wafer and facilitates the process. Preferably, protective insulator layers may be formed on the SOI wafer, prepared as above.

With the supporting wafer 1006 bonded, as shown in Fig. 11(d), the base wafer 1000 is ground to the desired thickness. The thickness can be desirously adjusted in grinding, for example from 50$\mu$m to 200$\mu$m.

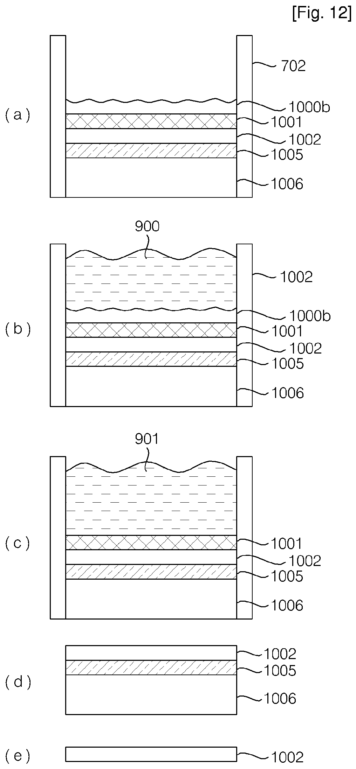

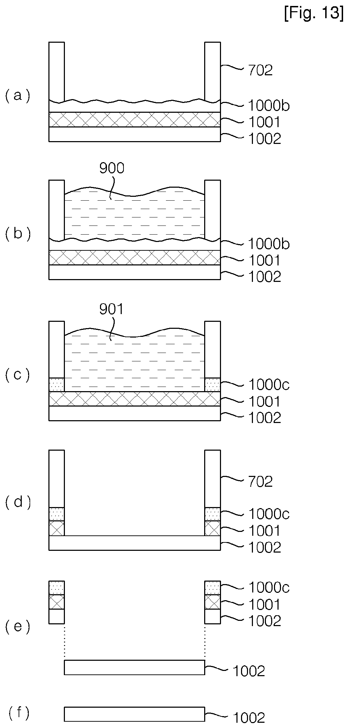

After grinding the base wafer 1000, as shown in Figs. 12 and 13, the remaining base wafer 1000b after grinding can be removed by wet etching it using the jig shown in Fig. 7. The supporting wafer 1006 is removed by dissolving the wax with aqueous solutions or a chemical agent after or before removing the remaining base wafer 1000b.

Referring to Fig. 12, the removal process by etching an entire surface of the base wafer using the jig is as follows.

As shown in Fig. 12(a), the edges of the SOI wafer is held with the jig so that the entire surface of the remaining base wafer 1000b to be removed by etching is exposed to the bath 702 of the upper plate701.

A KOH solution 900 is supplied onto the exposed surface of the remaining base wafer 1000b so that the base wafer is removed by etching as shown in Fig. 12(b). By draining the KOH solution 900 from and supplying a HF solution 901 onto the exposed surface, the insulator layer 1001 is removed by etching it (Fig. 12(c)). After draining the HF solution 901, the pure, flexible, single-crystal film of silicon is obtained by removing the wax 1005 and the supporting wafer 1006 (Fig. 12(d)(e)). The supporting wafer 1006 may be removed before removing the remaining base wafer 1000b.

By etching only with the KOH in the steps described above, the flexible film including the insulator layer and the single-crystal layer of silicon can be obtained.

Referring to Fig. 13, the removal process by etching a portion of the base wafer using the jig will be explained in more detail as below. If the flexible film is manufactured by such a method, it is not necessary to wet etch a peripheral of a wafer. That is, the flexible film of the desired shape can be manufactured by etching the necessary portion of the wafer using the jig, wherein the shape of the through hole of the bath is changed to a shape of a desired portion, and by cutting the unnecessary peripheral of the wafer, which is not etched. The wax 1005 and the supporting wafer 1006 may be removed before the etching process in order to avoid the cutting process of the supporting wafer 1006. Otherwise, after the etching process, the supporting wafer 1006 may be removed before cutting the unnecessary peripheral of the wafer.

After grinding the base wafer 1000 to the desired thickness as described above, the supporting wafer 1006 is removed by dissolving the wax with aqueous solutions or a chemical agent. After removing the supporting wafer 1006, the jig is positioned and pressed on the peripheral portion of the wafer so that a portion of the base wafer to be removed by etching is exposed (see Fig. 13(a)).

The KOH solution 900 is supplied onto the exposed surface of the remaining base wafer 1000b so that the base wafer is removed by etching as shown in Fig. 13(b). By draining the KOH solution from and supplying the HF solution onto the exposed surface, the insulator layer is removed by etching (see Fig. 13(c)). The peripheral portion 1000c of the base wafer, not removed by etching, is cut (Fig. 13(e)), so that the pure, flexible single-crystal film of silicon is obtained (Fig. 13(f)).

Also, by etching only with the KOH in the steps described above and cutting the peripheral portion 1000c of the base wafer, the flexible film including the insulator layer and the single-crystal layer of silicon can be obtained.

(Embodiment 5)

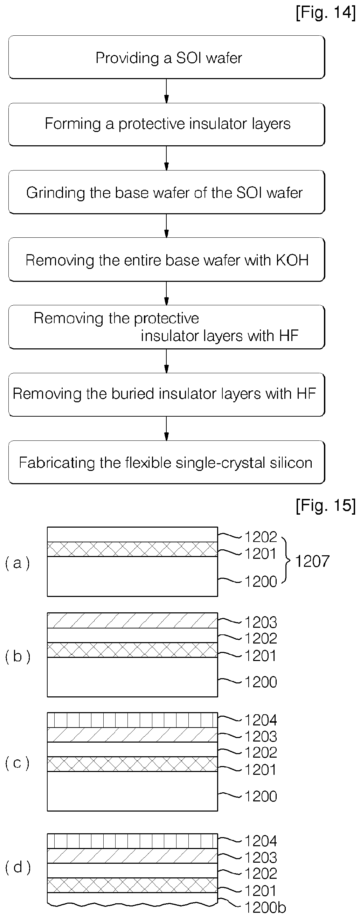

Referring to Figs. 14 to 16, another embodiment of the manufacturing process of the flexible single-crystal film will be explained in more detail as below. The present embodiment is similar to Embodiment 4, except that the supporting wafer is not bonded on the SOI wafer.

As shown in Fig. 15(a), a SOI wafer comprising a base wafer 1200, a buried insulator layer 1201 formed on the base wafer 1200, and a single-crystal layer 1202 of silicon formed on the buried insulator layer 1001 is provided. The thickness of the single-crystal layer is adjusted according to applications.

Protective insulator layers are formed on the SOI wafer provided as above. The protective insulator layers, which protect the single-crystal layer of silicon from being etched when the base wafer is removed by wet etching, includes an oxide film 1203 (Fig. 15(b)) and a nitride film 1204 (Fig. 15(c)) thereon.

After the protective insulator layers are formed on the SOI wafer, the base wafer 1200 is ground to the desired thickness (Fig. 15(d)). Since the supporting wafer is not bonded on the SOI wafer in the present embodiment, the SOI wafer may be fractured in a chuck of a grinding machine. Therefore, the thickness of the remaining base wafer after grinding should be thick. That is, the thickness of above 150μm can be desirously adjusted in grinding.

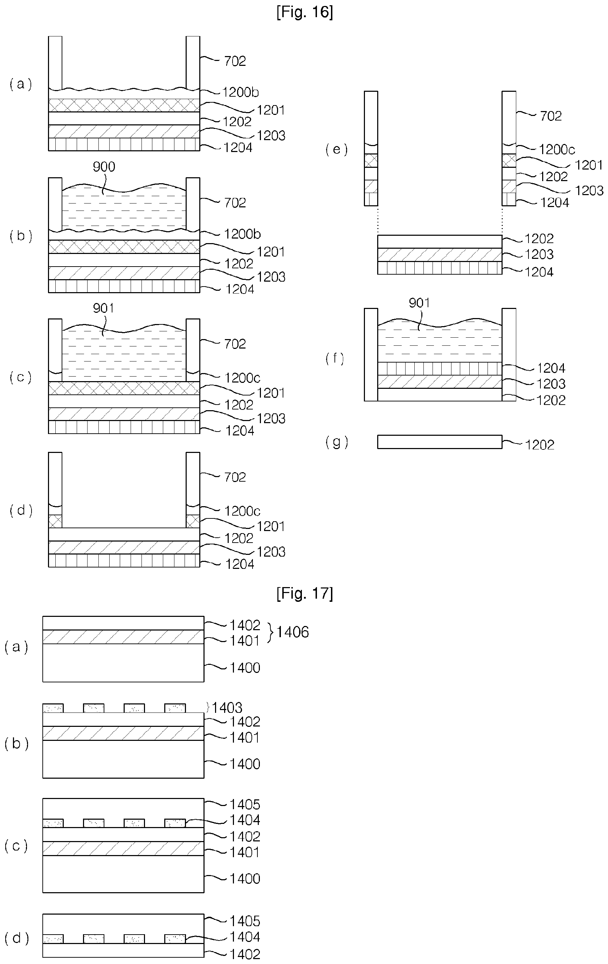

After grinding the base wafer 1200, as shown in Fig. 16, the remaining base wafer 1200b can be removed by wet etching it using the jig shown in Fig. 7.

Fig. 16 shows the removal process by etching a portion of the base wafer using the jig. If the flexible film is manufactured by such a method, it is not necessary to wet etch a peripheral of a wafer. That is, the flexible film of the desired shape can be manufactured by etching the necessary portion of the wafer using the jig, wherein the shape of the through hole of the bath is changed to a shape of desired portion, and by cutting the unnecessary peripheral of the wafer, which is not etched.

After grinding the base wafer 1200 to the desired thickness as shown in Fig. 15(g), the jig is positioned and pressed on the peripheral portion of the wafer so that a portion of the base wafer to be removed by etching is exposed (see Fig. 16(a)).

The KOH solution 900 is supplied onto the exposed surface of the base wafer so that the base wafer is removed by etching as shown in Fig. 16(b). By draining the KOH solution from and supplying the HF solution onto the exposed surface, the insulator layer 1201 is removed by etching (see Fig. 16(c)(d)). By etching only with the KOH in the steps described above, the flexible film including the insulator layer and the single-crystal layer of silicon can be obtained.

After removing the insulator layer 1201, the wafer including the protective insulator layers and the single-crystal layer of silicon is obtained by cutting the peripheral portion of the wafer, not removed by etching (see Fig. 16(e)). In order to remove the protective insulator layers 1203, 1204, the wafer is overturned and held with the jig so that the entire surface of the protective insulator layer 1204 is exposed. Then, the pure, flexible single-crystal film of silicon is obtained by etching the protective insulator layers 1203, 1204 with HF 901.

The removal of the buried insulator layer 1201 and the protective insulator layers 1203, 1204 with the HF solution may be performed by dipping the entire wafer without the jig in the HF solution.

Although the present embodiment describes the method for removing the remaining base wafer after grinding by holding the peripheral portion of the wafer with the jig, etching a portion of the base wafer, and cutting the peripheral portion, the remaining base wafer after grinding may be removed by holding the edges of the wafer with the jig to expose the entire surface of the remaining base wafer and etching it.

(Embodiment 6)

Referring to Figs. 17, a further manufacturing process of the flexible single-crystal film will be explained in more detail as below.

As shown in Fig. 17(a), a SOI wafer 1406 comprising a base wafer 1400, an insulator layer 1401 formed on the base wafer, and a single-crystal layer 1402 of silicon formed on the insulator layer is prepared.

Various electronic devices are manufactured on the single-crystal layer of the SOI wafer as prepared above by using a general semiconductor manufacturing process (see Fig. 17(b)). These electronic devices 1404 are manufactured according to the desired objectives. That is, these electronic devices may be designed according to the characteristics of various transistors, TFT arrays, logical circuits, and the like, and manufactured by a semiconductor manufacturing process.

A protective film 1405 for the devices is formed on the device layer on which various electronic devices are manufactured (see Fig. 17(c)). The protective film 1405 can be a general passivation film, an organic matter insulator layer, and the like.

The flexible film is obtained by removing the base wafer 1400 from the SOI wafer on which the devices are manufactured (see Fig. 17(d)). The removal of the base wafer can be performed by the methods according to Embodiments 1 to 5.

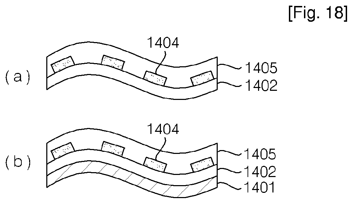

As shown in Fig. 18, the flexible film manufactured as above is flexible enough with the desired electronic devices manufactured on the single-crystal of silicon. Fig. 18(a) shows the flexible film wherein the devices are manufactured on the pure single-crystal of silicon, while Fig. 18(b) shows the flexible film wherein the devices are manufactured are formed on the flexible film including the insulator layer and the single-crystal layer of silicon and wherein the insulator layer protects the single-crystal layer of silicon and the devices during handling.

The flexible single-crystal film of the present invention as described thus far enables the devices of desired characteristics to be manufactured thereon and allows for overall flexibility. Particularly, the flexible single-crystal film can be easily manufactured using the single-crystal wafer.

Industrial Applicability

According to the present invention, the flexible film wherein desired various electronic devices are manufactured on the single-crystal layer is simply and stably manufactured. The present invention can realize the desired characteristics of electronic devices. By manufacturing various electronic devices on the single-crystal layer, an active layer for the devices is formed from the single-crystal layer. By using a semiconductor manufacturing process, a very high electronic mobility of $1000cm^2$ / Vsec is achieved. As such, electronic devices possess superior characteristics, and leakage current is also considerably reduced. It is possible to reduce the size of various electronic devices to the level of general semiconductor devices. It is also possible to design circuits with a design rule of about 30 nm, which can be practicable at present, by a stable high-temperature process and semiconductor photolithographic and etching process having good alignment accuracy, since the semiconductor manufacturing process is applied to silicon wafers.

Since the present invention can use a stable channel device of single-crystal, the present invention enables an SOP (system on panel), where all driver circuits are embedded in the panel, and embedded devices, where various memories, system ICs, processors, specific semiconductor circuits, and the like are embedded in a chip according to device purpose, to be flexible.

Using an appropriate thinning method, it is possible to manufacture the flexible single-crystal film and to improve productivity and reduce the cost of production by simplifying the manufacturing process of the flexible single-crystal film.

## Claims

**1.** A flexible film, comprising:

a single-crystal layer (1402) which is manufactured from a single-crystal wafer;
an electronic device (1404) formed on a surface of the single-crystal layer (1402);
one or more protection layers (1405) on the electronic device (1404); and
one or more flexible insulator layers (1401) on the other surface of said single-crystal layer (1402) wherein the single-crystal layer (1402) has a thickness of several tens of nanometers to several tens of micrometers and is flexible.

**2.** The flexible film according to claim 1, wherein said single-crystal layer (1402) comprises a silicon or a compound semiconductor.

**3.** A method for manufacturing a flexible film, comprising the steps of:

providing a SOI wafer comprising a base wafer (100), one or more buried insulator layers (101, 102) on the base wafer (100), and a single-crystal layer (202) on said one or more buried insulator layers (101, 102);
forming one or more protection layers (300, 301) on said single-crystal layer (202);
removing said base wafer (100); and
removing one or more of the insulator layers (101, 102),
wherein said step of providing the SOI wafer comprises the steps of:

providing the base wafer (100) and a bonding wafer (200);
forming said one or more buried insulator layers (101, 102) on said base wafer (100);
implanting hydrogen ions (201) into said bonding wafer (200);
bonding said base wafer (100) and said bonding wafer (200);
cleaving a region where hydrogen ions are implanted in said bonding wafer to cleave said bonding wafer (200); and
etching the cleaved surface of said bonding wafer (200) on said base wafer (100) to manufacture the SOI wafer wherein the single-crystal layer (202) is formed on the buried insulator layers (101, 102) of the base wafer (100) wherein said single-crystal layer (202) is formed from said bonding wafer (200) stayed on said insulator layers (101, 102), and has a thickness of several tens of nanometers to several tens of micrometers and is flexible.

**4.** The method according to claim 3, wherein said step of forming said one or more buried insulator layers (101, 102) on said base wafer (100) comprises the steps of:

forming a nitride film (101) on said base wafer (100); and
forming an oxide film (102) on said nitride film (101).

**5.** The method according to claim 3 or 4, further comprising the step of cleaning said base wafer (100) and said bonding (200) wafer before bonding them.

**6.** The method according to claim 3 or 4, wherein said step of removing said base wafer (100) comprises the step of removing the base wafer (100) by wet etching it.

**7.** The method according to claim 6, wherein KOH is used in wet etching said base wafer (100).

**8.** The method according to claim 3 or 4, wherein said step of forming said one or more protection layers (300, 301) on said single-crystal layer (202) comprises the steps of:

forming an oxide film (300) on said single-crystal layer (202); and
forming a nitride film (301) on said oxide film (300).

**9.** The method according to claim 3 or 4, wherein said step of removing one or more of the insulator layers (101, 102) comprises the step of removing all of the insulator layers (101, 102) by wet etching them with HF.

**10.** The method according to claim 3 or 4, wherein said step of removing one or more of the insulator layers (101, 102, 300, 301) comprises the step of removing either said one or more buried insulator layers (101, 102) or said one or more protection layers (300, 301) on the single-crystal layer (202) by wet etching them with HF.

**11.** The method according to claim 8, wherein said step of removing said base wafer (100) comprises the step of removing the base wafer (100) by wet etching it.

**12.** The method according to claim 11, wherein KOH is used in wet etching said base wafer (100).

**13.** The method according to claim 11, wherein said step of removing one or more of the insulator layers (101, 102) comprises the step of removing all of the insulator layers (101, 102) by wet etching them with HF.

**14.** The method according to claim 3 or 4, wherein said step of removing said base wafer (100) comprises the steps of:

grinding the base wafer (100) to a desired thickness;
removing the remaining base wafer (100) after grinding by wet etching it.

**15.** The method according to claim 14, wherein KOH is used in wet etching said base wafer (100).

**16.** The method according to claim 14, wherein said step of removing said base wafer (600) further comprises the steps of:

coating wax (605) on the protection layer (603, 604) and bonding said SOI wafer and a supporting wafer (606) before grinding the base wafer (600); and
removing the supporting wafer (606) after grinding the base wafer (600).

**17.** The method according to claim 14, wherein said step of removing one or more of the insulator layers (601, 603, 604) comprises the step of removing all of the protection layers (603, 604) and buried insulator layers (601) by wet etching them with HF.

**18.** The method according to claim 14, wherein said step of removing one or more of the insulator layers (601, 603, 604) comprises the step of removing either said one or more buried insulator layers (601) or said one or more protection layers (603, 604) on the single-crystal layer (602) by wet etching them with HF.

**19.** The method according to claim 3, wherein said step of removing said base wafer (800) comprises the steps of:

holding the SOI wafer with a jig to expose the lower surface of the base wafer; and
removing said base wafer (800) by etching it.

**20.** The method according to claim 19, wherein said step of holding the SOI wafer comprises the step of holding the edges of the SOI wafer with the jig to expose the entire lower surface of the base wafer (800).

**21.** The method according to claim 19, wherein said step of holding the SOI wafer comprises the step of holding the peripheral portion of the SOI wafer with the jig to expose a portion of the lower surface of the base wafer (800).

**22.** The method according to claim 21, wherein said step of removing said base wafer (800) comprises the step of cutting the peripheral portion which is held by the jig.

**23.** The method according to any one of claims 19 to 22, wherein said step of removing said base wafer (800) comprises the step of wet etching it.

**24.** The method according to claim 23, wherein KOH (900) is used in wet etching said base wafer (800).

**25.** The method according to claim 23, further comprising the step of removing one or more of the insulator layers (801) by wet etching them with HF.

**26.** The method according to claim 25, wherein said step of removing one or more of the insulator layers (801) by wet etching them with HF comprises the step of dipping the SOI wafer with the jig detached in an etching solution.

**27.** The method according to claim 3, wherein said step of removing said base wafer (1000) comprises the steps of:

bonding a supporting wafer (1006) to said single-crystal layer (1002) of said SOI wafer; and
removing said base wafer (1000) and said supporting wafer (1006).

**28.** The method according to claim 27, wherein said step of removing said base wafer (1000) comprises the steps of grinding said base wafer (1000) to a predetermined thickness, removing said supporting wafer (1006), holding the SOI wafer with a jig to expose the lower surface of the remaining base wafer (1000) after grinding, and removing the remaining base wafer (1000) by wet etching it.

**29.** The method according to claim 27, wherein said step of removing said base wafer (1000) comprises the steps of grinding said base wafer (1000) to a predetermined thickness, holding the SOI wafer with a jig to expose the lower surface of the remaining base wafer (1000) after grinding, removing the remaining base wafer (1000) by wet etching it, and removing said supporting wafer (1006).

**30.** The method according to claim 3, wherein said step of removing said base wafer (1200) comprises the steps of:

grinding said base wafer (1200) to a predetermined thickness;
holding the SOI wafer with a jig to expose the lower surface of the remaining base wafer (1200) after grinding; and
removing the remaining base wafer (1200) by wet etching it.

**31.** The method according to claim 30, further comprising the step of forming one or more protection layers (1203, 1204) on said single-crystal layer (1202) before grinding said base wafer (1200), wherein the remaining base wafer (1200) is above 150 $\mu$m in thickness.

**32.** The method according to claim 31, further comprising the step of removing said one or more buried insulator layers (1201) and/or said one or more protection layers after removing said base wafer (1200).

**33.** The method according to any one of claims 28 to 32, wherein said step of holding the SOI wafer with the jig comprises the step of holding the edges of the SOI wafer with the jig to expose the entire lower surface of the base wafer (1200).

**34.** The method according to any one of claims 28 to 32, wherein said step of holding the SOI wafer with the jig comprises the step of holding the peripheral portion of the SOI wafer with the jig to expose a portion of the lower surface of the base wafer (1200), and further comprising the step of cutting the peripheral portion which is held by the jig after wet etching the portion of said base wafer after grinding.

**35.** The method according to any one of claims 27 to 32, further comprising the step of removing said one or more buried insulator layers (1201) after removing said base wafer (1200).

**36.** The method according to any one of claims 27 to 29, further comprising the step of forming one or more protection layers on said single-crystal layer (1002) before bonding a supporting wafer to said single-crystal layer of said SOI wafer.

**37.** The method according to any one of claims 27 to 29, wherein the step of bonding a supporting wafer (1006) to said single-crystal layer (1002) of said SOI wafer comprises the steps of coating wax on said single-crystal layer (1002) of said SOI wafer and bonding a supporting wafer (1006) to said single-crystal layer of said SOI wafer.

**38.** The method according to claim 36, wherein the step of bonding the supporting wafer (1006) to said single-crystal layer (1002) of said SOI wafer comprises the steps of coating wax on the protection layer and bonding said SOI wafer and a supporting wafer (1006) before grinding the base wafer (1000); and further comprising the step of removing said one or more buried insulator layers and/or said one or more protection layers after removing said base wafer (1000) and said supporting wafer (1006).

**39.** The method according to any one of claims 28 to 32, wherein KOH is used in wet etching said base wafer (1000).

**40.** The method according to claim 3, further comprising the step of:
forming one or more device layers by manufacturing electronic devices on the single-crystal layer (1402).

**41.** The method according to claim 40, wherein said step of removing said base wafer (1400) comprises the step of wet etching the base wafer (1400).

**42.** The method according to claim 40, wherein said step of removing said base wafer (1400) comprising the steps of
grinding the base wafer (1400) to a desired thickness; and
removing the remaining base wafer (1400) after grinding by wet etching it.

**43.** The method according to claim 40, wherein said step of removing said base wafer (1400) comprises the steps of:

holding the SOI wafer (1406) with a jig to expose the lower surface of the base wafer (1600); and
removing the base wafer (1600) by wet etching it.

**44.** The method according to claim 40, wherein said step of removing said base wafer (1600) comprises the steps of:

grinding the base wafer (1600) to a desired thickness;
holding the SOI wafer (1406) with a jig to expose the lower surface of the base wafer (1600); and
removing the base wafer (1600) by wet etching it.

**45.** The method according to any one of claims 41 to 44, wherein KOH is used in wet etching said base wafer (1600).

**46.** The method according to any one of claims 40 to 44, further comprising the step of removing said one or more insulator layers (1401) by wet etching them with HF.

**47.** The method according to any one of claims 40 to 44, wherein said step of forming the device layer by manufacturing the electronic devices (1404) on the single-crystal layer (1402) comprises the step of using a semiconductor manufacturing process.

## Patentansprüche

**1.** Flexible Schicht, mit:

einer aus einem Einkristallwafer hergestellten Einkristallschicht (1402);
einem auf einer Oberfläche der Einkristallschicht (1402) ausgebildeten elektronischen Bauelement (1404);
einer oder mehreren Schutzschichten (1405) auf dem elektronischen Bauelement (1404); und
einer oder mehreren flexiblen Isolatorschichten (1401) auf der anderen Oberfläche der Einkristallschicht (1402), wobei die Einkristallschicht (1402) eine Dicke von einigen zehn Nanometern bis einigen zehn Mikrometern hat und flexibel ist.

**2.** Flexible Schicht nach Anspruch 1, wobei die Einkristallschicht (1402) einen Silizium- oder einen Verbindungshalbleiter aufweist.

**3.** Verfahren zum Herstellen einer flexiblen Schicht, mit den Schritten:

Bereitstellen eines SOI-Wafers mit einem Basiswafer (100), einer oder mehreren eingebetteten Isolatorschichten (101, 102) auf dem Basiswafer (100) und einer Einkristallschicht (202) auf der einen oder den mehreren eingebetteten Isolatorschichten (101, 102);
Ausbilden einer oder mehrerer Schutzschichten (300, 301) auf der Einkristallschicht (202);
Entfernen des Basiswafers (100); und
Entfernen einer oder mehrerer der Isolatorschichten (101, 102),
wobei der Schritt zum Bereitstellen des SOI-Wafers die Schritte aufweist:

Bereitstellen des Basiswafers (100) und eines Bondwafers (200);
Ausbilden der einen oder mehreren eingebetteten Isolatorschichten (101, 102) auf dem Basiswafer (100);
Implantieren von Wasserstoffionen (201) in den Bondwafer (200);
Verbinden des Basiswafers (100) und des Bondwafers (200);
Abtrennen eines Bereichs, wo Wasserstoffionen in den Bondwafer implantiert sind, um den Bondwafer (200) abzutrennen; und
Ätzen der abgetrennten Oberfläche des Bondwafers (200) auf dem Basiswafer (100) zum Herstellen des SOI-Wafers, wobei die Einkristallschicht (202) auf den eingebetteten Isolatorschichten (101, 102) des Basiswafers (100) ausgebildet ist, wobei die Einkristallschicht (202) von dem auf den Isolatorschichten (101, 102) verbliebenen Bondwafer (200) gebildet wird und eine Dicke von mehreren zehn Nanometern bis zu mehreren zehn Mikrometern hat und flexibel ist.

**4.** Verfahren nach Anspruch 3, wobei der Schritt zum Ausbilden der einen oder mehreren eingebetteten Isolatorschichten (101, 102) auf dem Basiswafer (100) die Schritte aufweist:

Ausbilden einer Nitridschicht (101) auf dem Basiswafer (100); und
Ausbilden einer Oxidschicht (102) auf der Nitridschicht (101).

5. Verfahren nach Anspruch 3 oder 4, ferner mit dem Schritt zum Reinigen des Basiswafers (100) und des Bondwafers (200) vor dem Verbinden des Basis- und des Bondwafers.

6. Verfahren nach Anspruch 3 oder 4, wobei der Schritt zum Entfernen des Basiswafers (100) den Schritt zum Entfernen des Basiswafers (100) durch Nassätzen des Basiswafers (100) aufweist.

7. Verfahren nach Anspruch 6, wobei beim Nassätzen des Basiswafers (100) KOH verwendet wird.

8. Verfahren nach Anspruch 3 oder 4, wobei der Schritt zum Ausbilden der einen oder mehreren Schutzschichten (300, 301) auf der Einkristallschicht (202) die Schritte aufweist:

Ausbilden einer Oxidschicht (300) auf der Einkristallschicht (202); und
Ausbilden einer Nitridschicht (301) auf der Oxidschicht (300).

9. Verfahren nach Anspruch 3 oder 4, wobei der Schritt zum Entfernen einer oder mehrerer der Isolatorschichten (101, 102) den Schritt zum Entfernen aller Isolatorschichten (101, 102) durch Nassätzen dieser mit HF aufweist.

10. Verfahren nach Anspruch 3 oder 4, wobei der Schritt zum Entfernen einer oder mehrerer der Isolatorschichten (101, 102, 300, 301) den Schritt zum Entfernen entweder der einen oder mehreren eingebetteten Isolatorschichten (101, 102) oder der einen oder mehreren Schutzschichten (300, 301) auf der Einkristallschicht (202) durch Nassätzen dieser mit HF aufweist.

11. Verfahren nach Anspruch 8, wobei der Schritt zum Entfernen des Basiswafers (100) den Schritt zum Entfernen des Basiswafers (100) durch Nassätzen des Basiswafers aufweist.

12. Verfahren nach Anspruch 11, wobei beim Nassätzen des Basiswafers (100) KOH verwendet wird.

13. Verfahren nach Anspruch 11, wobei der Schritt zum Entfernen einer oder mehrerer der Isolatorschichten (101, 102) den Schritt zum Entfernen aller Isolatorschichten (101, 102) durch Nassätzen dieser mit HF aufweist.

14. Verfahren nach Anspruch 3 oder 4, wobei der Schritt zum Entfernen des Basiswafers (100) die folgenden Schritte aufweist:

Schleifen des Basiswafers (100) auf eine gewünschte Dicke;
Entfernen des verbleibenden Basiswafers (100) nach dem Schleifen durch Nassätzen des Basiswafers.

15. Verfahren nach Anspruch 14, wobei beim Nassätzen des Basiswafers (100) KOH verwendet wird.

16. Verfahren nach Anspruch 14, wobei der Schritt zum Entfernen des Basiswafers (600) ferner die folgenden Schritte aufweist:

Auftragen von Wachs (605) auf die Schutzschicht (603, 604) und Verbinden des SOI-Wafers und eines Trägerwafers (606) vor dem Schleifen des Basiswafers (600); und
Entfernen des Trägerwafers (606) nach dem Schleifen des Basiswafers (600).

17. Verfahren nach Anspruch 14, wobei der Schritt zum Entfernen einer oder mehrerer der Isolatorschichten (601, 603, 604) den Schritt zum Entfernen aller Schutzschichten (603, 604) und aller eingebetteten Isolatorschichten (601) durch Nassätzen der Schichten mit HF aufweist.

18. Verfahren nach Anspruch 14, wobei der Schritt zum Entfernen einer oder mehrerer der Isolatorschichten (601, 603, 604) den Schritt zum Entfernen entweder der einen oder mehreren eingebetteten Isolatorschichten (601) oder der einen oder mehreren Schutzschichten (603, 604) auf der Einkristallschicht (602) durch Nassätzen der entsprechenden Schichten mit HF aufweist.

19. Verfahren nach Anspruch 3, wobei der Schritt zum Entfernen des Basiswafers (800) die folgenden Schritte aufweist:

Halten des SOI-Wafers durch eine Einspannvorrichtung, um die untere Oberfläche des Basiswafers freizulegen; und
Entfernen des Basiswafers (800) durch Ätzen des Basiswafers.

20. Verfahren nach Anspruch 19, wobei der Schritt zum Halten des SOI-Wafers den Schritt zum Halten der Ränder des SOI-Wafers durch die Einspannvorrichtung aufweist, um die gesamte untere Oberfläche des Basiswafers (800) freizulegen.

21. Verfahren nach Anspruch 19, wobei der Schritt zum Halten des SOI-Wafers den Schritt zum Halten des Umfangsabschnitts des SOI-Wafers durch die Einspannvorrichtung aufweist, um einen Abschnitt der unteren Fläche des Basiswafers (800) freizulegen.

**22.** Verfahren nach Anspruch 21, wobei der Schritt zum Entfernen des Basiswafers (800) den Schritt zum Schneiden des Umfangsabschnitts aufweist, der durch die Einspannvorrichtung gehalten wird.

**23.** Verfahren nach einem der Ansprüche 19 bis 22, wobei der Schritt zum Entfernen des Basiswafers (800) den Schritt zum Nassätzen des Basiswafers aufweist.

**24.** Verfahren nach Anspruch 23, wobei beim Nassätzen des Basiswafers (800) KOH (900) verwendet wird.

**25.** Verfahren nach Anspruch 23, ferner mit dem Schritt zum Entfernen einer oder mehrerer der Isolatorschichten (801) durch Nassätzen der Isolatorschichten mit HF.

**26.** Verfahren nach Anspruch 25, wobei der Schritt zum Entfernen einer oder mehrerer der Isolatorschichten (801) durch Nassätzen der Isolatorschichten mit HF den Schritt zum Eintauchen des von der Einspannvorrichtung getrennten SOI-Wafers in eine Ätzlösung aufweist.

**27.** Verfahren nach Anspruch 3, wobei der Schritt zum Entfernen des Basiswafers (1000) die Schritte aufweist:

Verbinden eines Trägerwafers (1006) mit der Einkristallschicht (1002) des SOI-Wafers; und
Entfernen des Basiswafers (1000) und des Trägerwafers (1006).

**28.** Verfahren nach Anspruch 27, wobei der Schritt zum Entfernen des Basiswafers (1000) die Schritte zum Schleifen des Basiswafers (1000) auf eine vorgegebene Dicke, Entfernen des Trägerwafers (1006), Halten des SOI-Wafers durch eine Einspannvorrichtung zum Freilegen der unteren Oberfläche des verbleibenden Basiswafers (1000) nach dem Schleifen und Entfernen des verbleibenden Basiswafers (1000) durch Nassätzen des Basiswafers aufweist.

**29.** Verfahren nach Anspruch 27, wobei der Schritt zum Entfernen des Basiswafers (1000) die Schritte zum Schleifen des Basiswafers (1000) auf eine vorgegebene Dicke, Halten des SOI-Wafers durch eine Einspannvorrichtung zum Freilegen der unteren Oberfläche des verbleibenden Basiswafers (1000) nach dem Schleifen, Entfernen des verbleibenden Basiswafers (1000) durch Nassätzen des Basiswafers und Entfernen des Trägerwafers (1006) aufweist.

**30.** Verfahren nach Anspruch 3, wobei der Schritt zum Entfernen des Basiswafers (1200) die Schritte aufweist:

Schleifen des Basiswafers (1200) auf eine vorgegebene Dicke;
Halten des SOI-Wafers durch eine Einspannvorrichtung zum Freilegen der unteren Oberfläche des verbleibenden Basiswafers (1200) nach dem Schleifen; und
Entfernen des verbleibenden Basiswafers (1200) durch Nassätzen des Basiswafers.

**31.** Verfahren nach Anspruch 30, ferner mit dem Schritt zum Ausbilden einer oder mehrerer Schutzschichten (1203, 1204) auf der Einkristallschicht (1202) vor dem Schleifen des Basiswafers (1200), wobei der verbleibende Basiswafer (1200) eine Dicke von mehr als 150 μm hat.

**32.** Verfahren nach Anspruch 31, ferner mit dem Schritt zum Entfernen der einen oder mehreren eingebetteten Isolatorschichten (1201) und/oder der einen oder mehreren Schutzschichten nach dem Entfernen des Basiswafers (1200).

**33.** Verfahren nach einem der Ansprüche 28 bis 32, wobei der Schritt zum Halten des SOI-Wafers durch die Einspannvorrichtung den Schritt zum Halten der Ränder des SOI-Wafers durch die Einspannvorrichtung zum Freilegen der gesamten unteren Oberfläche des Basiswafers (1200) aufweist.

**34.** Verfahren nach einem der Ansprüche 28 bis 32, wobei der Schritt zum Halten des SOI-Wafers durch die Einspannvorrichtung den Schritt zum Halten des Umfangsabschnitts des SOI-Wafers durch die Einspannvorrichtung zum Freilegen eines Abschnitts der unteren Oberfläche des Basiswafers (1200) aufweist, und ferner mit dem Schritt zum Schneiden des Umfangsabschnitts, der durch die Einspannvorrichtung gehalten wird, nach dem Nassätzen des Abschnitts des Basiswafers nach einem Schleifvorgang.

**35.** Verfahren nach einem der Ansprüche 27 bis 32, ferner mit dem Schritt zum Entfernen der einen oder mehreren eingebetteten Isolatorschichten (1201) nach dem Entfernen des Basiswafers (1200).

**36.** Verfahren nach einem der Ansprüche 27 bis 29, ferner mit dem Schritt zum Ausbilden einer oder mehrerer Schutzschichten auf der Einkristallschicht (1002) vor dem Verbinden eines Trägerwafers mit der Einkristallschicht des SOI-Wafers.

**37.** Verfahren nach einem der Ansprüche 27 bis 29, wobei der Schritt zum Verbinden eines Trägerwafers (1006) mit der Einkristallschicht (1002) des SOI-Wafers die Schritte zum Auftragen von Wachs auf die Einkristallschicht (1002) des SOI-Wafers und Verbinden eines Trägerwafers (1006) mit der Einkristallschicht des SOI-Wafers aufweist.

**38.** Verfahren nach Anspruch 36, wobei der Schritt zum Verbinden des Trägerwafers (1006) mit der Einkristallschicht (1002) des SOI-Wafers die Schritte zum Auftragen von Wachs auf die Schutzschicht und Verbinden des SOI-Wafers und eines Trägerwafers (1006) vor dem Schleifen des Basiswafers (1000) aufweist, und ferner mit dem Schritt zum Entfernen der einen oder mehreren eingebetteten Isolatorschichten und/oder der einen oder mehreren Schutzschichten nach dem Entfernen des Basiswafers (1000) und des Trägerwafers (1006).

**39.** Verfahren nach einem der Ansprüche 28 bis 32, wobei beim Nassätzen des Basiswafers (1000) KOH verwendet wird.

**40.** Verfahren nach Anspruch 3, ferner mit dem Schritt: Ausbilden einer oder mehrerer Bauelementlagen durch Herstellen elektronischer Bauelemente auf der Einkristallschicht (1402).

**41.** Verfahren nach Anspruch 40, wobei der Schritt zum Entfernen des Basiswafers (1400) den Schritt zum Nassätzen des Basiswafers (1400) aufweist.

**42.** Verfahren nach Anspruch 40, wobei der Schritt zum Entfernen des Basiswafers (1400) die Schritte aufweist:

Schleifen des Basiswafers (1400) auf eine gewünschte Dicke; und
Entfernen des verbleibenden Basiswafers (1400) nach dem Schleifen durch Nassätzen des Basiswafers.

**43.** Verfahren nach Anspruch 40, wobei der Schritt zum Entfernen des Basiswafers (1400) die Schritte aufweist:

Halten des SOI-Wafers (1406) durch eine Einspannvorrichtung zum Freilegen der unteren Oberfläche des Basiswafers (1600); und
Entfernen des Basiswafers (1600) durch Nassätzen des Basiswafers (1600).

**44.** Verfahren nach Anspruch 40, wobei der Schritt zum Entfernen des Basiswafers (1600) die Schritte aufweist:

Schleifen des Basiswafers (1600) auf eine gewünschte Dicke;
Halten des SOI-Wafers (1406) durch eine Einspannvorrichtung zum Freilegen der unteren Oberfläche des Basiswafers (1600); und
Entfernen des Basiswafers (1600) durch Nassätzen des Basiswafers (1600).

**45.** Verfahren nach einem der Ansprüche 41 bis 44, wobei beim Nassätzen des Basiswafers (1600) KOH verwendet wird.

**46.** Verfahren nach einem der Ansprüche 40 bis 44, ferner mit dem Schritt zum Entfernen der einen oder mehreren Isolatorschichten (1401) durch Nassätzen der Schichten mit HF.

**47.** Verfahren nach einem der Ansprüche 40 bis 44, wobei der Schritt zum Ausbilden der Bauelementlage durch Herstellen der elektronischen Bauelemente (1404) auf der Einkristallschicht (1402) den Schritt zum Verwenden eines Halbleiterherstellungsprozesses aufweist.

**Revendications**

**1.** Film souple comprenant :

une couche monocristalline (1402) qui est fabriquée à partir d'une plaquette monocristalline ;
un dispositif électronique (1404) formé sur une surface de la couche monocristalline (1402) ;
une ou plusieurs couches de protection (1405) sur le dispositif électronique (1404) ; et
une ou plusieurs couches isolantes souples (1401) sur l'autre surface de ladite couche monocristalline (1402), où la couche monocristalline (1402) a une épaisseur allant de plusieurs dizaines de nanomètres à plusieurs dizaines de micromètres et est souple.

**2.** Film souple selon la revendication 1, dans lequel ladite couche monocristalline (1402) comprend du silicium ou un composé semi-conducteur.

**3.** Procédé destiné à la fabrication d'un film souple, comprenant les étapes :

de mise à disposition d'une plaquette SOI comprenant une plaquette de base (100), une ou plusieurs couches isolantes enfouies (101, 102) sur la plaquette de base (100), et une couche monocristalline (202) sur ladite une ou plusieurs couches isolantes enfouies (101, 102) ;
de formation d'une ou de plusieurs couches de protection (300, 301) sur ladite couche monocristalline (202) ;
de suppression de ladite plaquette de base (100) ; et
de suppression d'une ou de plusieurs couches isolantes (101, 102),

où ladite étape de mise à disposition de la plaquette SOI comprend les étapes :

de mise à disposition de la plaquette de base (100) et d'une plaquette de liaison (200) ;
de formation de ladite une ou plusieurs couches isolantes enfouies (101, 102) sur ladite plaquette de base (100) ;
d'implantation d'ions hydrogène (201) à l'intérieur de ladite plaquette de liaison (200) ;
de liaison de ladite plaquette de base (100) et de ladite plaquette de liaison (200) ;
de séparation d'une zone où les ions hydrogène sont implantés dans ladite plaquette de liaison pour séparer ladite plaquette de liaison (200) ; et
de gravure de la surface séparée de ladite plaquette de liaison (200) sur ladite plaquette de base (100) pour fabriquer la plaquette SOI dans laquelle la couche monocristalline (202) est formée sur les couches isolantes enfouies (101, 102) de la plaquette de base (100), où ladite couche monocristalline (202) est formée à partir de ladite plaquette de liaison (200) restée sur lesdites couches isolantes (101, 102) et a une épaisseur allant de plusieurs dizaines de nanomètres à plusieurs dizaines de micromètres et est souple.

**4.** Procédé selon la revendication 3, dans lequel ladite étape de formation de ladite une ou desdites plusieurs couches isolantes enfouies (101, 102), sur ladite plaquette de base (100) comprend les étapes :

de formation d'un film de nitrure (101) sur ladite plaquette de base (100) ; et
de formation d'un film d'oxyde (102) sur ledit film de nitrure (101).

**5.** Procédé selon la revendication 3 ou la revendication 4, comprenant en outre l'étape de nettoyage de ladite plaquette de base (100) et de ladite plaquette de liaison (200) avant de les relier.

**6.** Procédé selon la revendication 3 ou la revendication 4, dans lequel ladite étape de suppression de ladite plaquette de base (100) comprend l'étape de suppression de la plaquette de base (100) en la soumettant à une gravure humide.

**7.** Procédé selon la revendication 6, dans lequel du KOH est utilisé dans la gravure humide de ladite plaquette de base (100).

**8.** Procédé selon la revendication 3 ou la revendication 4, dans lequel ladite étape de formation de ladite une ou desdites plusieurs couches de protection (300, 301) sur ladite couche monocristalline (202) comprend les étapes :

de formation d'un film d'oxyde (300) sur ladite couche monocristalline (202) ; et
de formation d'un film de nitrure (301) sur ledit film d'oxyde (300).

**9.** Procédé selon la revendication 3 ou la revendication 4, dans lequel ladite étape de suppression d'une ou de plusieurs des couches isolantes (101, 102) comprend l'étape de suppression de toutes les couches isolantes (101, 102) en les soumettant à une gravure humide avec de l'HF.

**10.** Procédé selon la revendication 3 ou la revendication 4, dans lequel ladite étape de suppression d'une ou de plusieurs des couches isolantes (101, 102, 300, 301) comprend l'étape de suppression soit de ladite une ou desdites plusieurs couches isolantes enfouies (101, 102), soit de ladite une ou desdites plusieurs couches de protection (300, 301), sur la couche monocristalline (202) en les soumettant à une gravure humide avec de l'HF.

**11.** Procédé selon la revendication 8, dans lequel ladite étape de suppression de ladite plaquette de base (100) comprend l'étape de suppression de la plaquette de base (100) en la soumettant à une gravure humide.

**12.** Procédé selon la revendication 11, dans lequel du KOH est utilisé dans la gravure humide de ladite plaquette de base (100).

**13.** Procédé selon la revendication 11, dans lequel ladite étape de suppression d'une ou de plusieurs des couches isolantes (101, 102) comprend l'étape de suppression de toutes les couches isolantes (101, 102) en les soumettant à une gravure humide avec de l'HF.

**14.** Procédé selon la revendication 3 ou la revendication 4, dans lequel ladite étape de suppression de ladite plaquette de base (100) comprend les étapes :

de meulage de la plaquette de base (100) jusqu'à une épaisseur désirée ;
de suppression de la plaquette de base restante (100) après meulage en la soumettant à une gravure humide.

**15.** Procédé selon la revendication 14, dans lequel du KOH est utilisé dans la gravure humide de ladite plaquette de base (100).

**16.** Procédé selon la revendication 14, dans lequel ladite étape de suppression de ladite plaquette de base (600) comprend en outre les étapes :

d'application d'une cire (605) sur la couche protectrice (603, 604) et de liaison de ladite plaquette SOI et d'une plaquette de support (606) avant le meulage de la plaquette de base (600) ; et
de suppression de la plaque de support (606) après le meulage de la plaquette de base (600).

**17.** Procédé selon la revendication 14, dans lequel ladite étape de suppression d'une ou de plusieurs des couches isolantes (601, 603, 604) comprend l'étape de suppression de toutes les couches de protection (603, 604) et des couches isolantes enfouies (601) en les soumettant à une gravure humide avec de l'HF.

**18.** Procédé selon la revendication 14, dans lequel ladite étape de suppression d'une ou de plusieurs des couches isolantes (601, 603, 604) comprend l'étape de suppression soit de ladite une ou desdites plusieurs couches isolantes enfouies (601), soit de ladite une ou desdites plusieurs couches de protection (603, 604) sur la couche monocristalline (602) en les soumettant à une gravure humide avec de l'HF.

**19.** Procédé selon la revendication 3, dans lequel ladite étape de suppression de ladite plaquette de base (800) comprend les étapes :

de maintien de la plaquette SOI par une mâchoire pour exposer la surface inférieure de la plaquette de base ; et
de suppression de ladite plaquette de base (800) en la soumettant à une gravure.

**20.** Procédé selon la revendication 19, dans lequel ladite étape de maintien de la plaquette SOI comprend l'étape de maintien des bords de la plaquette SOI par la mâchoire pour exposer la totalité de la surface inférieure de la plaquette de base (800).

**21.** Procédé selon la revendication 19, dans lequel ladite étape de maintien de la plaquette SOI comprend l'étape de maintien de la partie périphérique de la plaquette SOI par la mâchoire pour exposer une partie de la surface inférieure de la plaquette de base (800).

**22.** Procédé selon la revendication 21, dans lequel ladite étape de suppression de ladite plaquette de base (800) comprend l'étape de découpage de la partie périphérique qui est tenue par la mâchoire.

**23.** Procédé selon l'une quelconque des revendications 19 à 22, dans lequel ladite étape de suppression de ladite plaquette de base (800) comprend l'étape de sa gravure humide.

**24.** Procédé selon la revendication 23, dans lequel du KOH (900) est utilisé dans la gravure humide de ladite plaquette de base (800).

**25.** Procédé selon la revendication 23, comprenant en outre l'étape de suppression d'une ou de plusieurs des couches isolantes (801) en les soumettant à une gravure humide avec de l'HF.

**26.** Procédé selon la revendication 25, dans lequel ladite étape de suppression d'une ou de plusieurs des couches isolantes (801) en les soumettant à une gravure humide avec de l'HF comprend l'étape de trempage de la plaquette SOI, avec la mâchoire retirée, dans une solution de gravure.

**27.** Procédé selon la revendication 3, dans lequel ladite étape de suppression de ladite plaquette de base (1000) comprend les étapes :

de liaison d'une plaquette de support (1006) à ladite couche monocristalline (1002) de ladite plaquette SOI ; et
de suppression de ladite plaquette de base (1000) et de ladite plaquette de support (1006).

**28.** Procédé selon la revendication 27, dans lequel ladite étape de suppression de ladite plaquette de base (1000) comprend les étapes de meulage de ladite plaquette de base (1000) jusqu'à une épaisseur prédéterminée, de suppression de ladite plaquette de support (1006), de maintien de la plaquette SOI par une mâchoire pour exposer la surface inférieure de la plaquette de base restante (1000) après meulage, et de suppression de la plaquette de base restante (1000) en la soumettant à une gravure humide.

**29.** Procédé selon la revendication 27, dans lequel ladite étape de suppression de ladite plaquette de base (1000) comprend les étapes de meulage de ladite plaquette de base (1000) jusqu'à une épaisseur prédéterminée, de maintien de la plaquette SOI par une mâchoire pour exposer la surface inférieure de la plaquette de base restante (1000) après meulage, de suppression de la plaquette de base restante (1000) en la soumettant à une gravure humide, et de suppression de ladite plaquette de support (1006).

**30.** Procédé selon la revendication 3, dans lequel ladite étape de suppression de ladite plaquette de base (1200) comprend les étapes :

de meulage de ladite plaquette de base (1200) jusqu'à une épaisseur prédéterminée ;
de maintien de la plaquette SOI par une mâchoire pour exposer la surface inférieure de la plaquette de base restante (1200) après meulage ;

et
de suppression de la plaquette de base restante (1200) en la soumettant à une gravure humide.

**31.** Procédé selon la revendication 30, comprenant en outre l'étape de formation d'une ou de plusieurs couches de protection (1203, 1204) sur ladite couche monocristalline (1202) avant meulage de ladite plaquette de base (1200), où la plaquette de base (1200) restante a une épaisseur supérieure à 150 μm.

**32.** Procédé selon la revendication 31, comprenant en outre l'étape de suppression de ladite une ou desdites plusieurs couches isolantes enfouies (1201) et/ou de ladite une ou desdites plusieurs couches de protection après la suppression de ladite plaquette de base (1200).

**33.** Procédé selon l'une quelconque des revendications 28 à 32, dans lequel ladite étape de maintien de la plaquette SOI par la mâchoire comprend l'étape de maintien des bords de la plaquette SOI par la mâchoire pour exposer la totalité de la surface inférieure de la plaquette de base (1200).

**34.** Procédé selon l'une quelconque des revendications 28 à 32, dans lequel ladite étape de maintien de la plaquette SOI par la mâchoire comprend l'étape de maintien de la partie périphérique de la plaquette SOI par la mâchoire pour exposer une partie de la surface inférieure de la plaquette de base (1200), et comprenant en outre l'étape de découpage de la partie périphérique qui est tenue par la mâchoire après la gravure humide de la partie de ladite plaquette de base après meulage.

**35.** Procédé selon l'une quelconque des revendications 27 à 32, comprenant en outre l'étape de suppression de ladite une ou desdites plusieurs couches isolantes enfouies (1201) après la suppression de ladite plaquette de base (1200).

**36.** Procédé selon l'une quelconque des revendications 27 à 29, comprenant en outre l'étape de formation d'une ou de plusieurs couches de protection sur ladite couche monocristalline (1002) avant la liaison d'une plaquette de support à ladite couche monocristalline de ladite plaquette SOI.

**37.** Procédé selon l'une quelconque des revendications 27 à 29, dans lequel l'étape de liaison d'une plaquette de support (1006) à ladite couche monocristalline (1002) de ladite plaquette SOI comprend les étapes d'application d'une cire sur ladite couche monocristalline (1002) de ladite plaquette SOI et de liaison d'une plaquette de support (1006) à ladite couche monocristalline de ladite plaquette SOI.

**38.** Procédé selon la revendication 36, dans lequel l'étape de liaison de la plaquette de support (1006) à ladite couche monocristalline (1002) de ladite plaquette SOI comprend les étapes d'application d'une cire sur la couche de protection et de liaison de ladite plaquette SOI et d'une plaquette de support (1006) avant le meulage de la plaquette de base (1000) ; et comprenant en outre l'étape de suppression de ladite une ou desdites plusieurs couches isolantes enfouies et/ou de ladite une ou desdites plusieurs couches de protection après la suppression de ladite plaquette de base (1000) et de ladite plaquette de support (1006).

**39.** Procédé selon l'une quelconque des revendications 28 à 32, dans lequel du KOH est utilisé dans la gravure humide de ladite plaquette de base (1000).

**40.** Procédé selon la revendication 3, comprenant en outre l'étape :
de formation d'une ou de plusieurs couches de dispositif par la fabrication de dispositifs électroniques sur la couche monocristalline (1402).

**41.** Procédé selon la revendication 40, dans lequel ladite étape de suppression de ladite plaquette de base (1400) comprend l'étape de gravure humide de la plaquette de base (1400).

**42.** Procédé selon la revendication 40, dans lequel ladite étape de suppression de ladite plaquette de base (1400) comprend les étapes :

de meulage de la plaquette de base (1400) jusqu'à une épaisseur désirée ; et
de suppression de la plaquette de base (1400) restante après le meulage en la soumettant à une gravure humide.

**43.** Procédé selon la revendication 40, dans lequel ladite étape de suppression de ladite plaquette de base (1400) comprend les étapes :

de maintien de la plaquette SOI (1406) par une mâchoire pour exposer la surface inférieure de la plaquette de base (1600) ; et
de suppression de la plaquette de base (1600) en la soumettant à une gravure humide.

**44.** Procédé selon la revendication 40, dans lequel ladite étape de suppression de ladite plaquette de base (1600) comprend les étapes :

de meulage de la plaquette de base (1600) jusqu'à une épaisseur désirée ;
de maintien de la plaquette SOI (1406) par une mâchoire pour exposer la surface inférieure de la plaquette de base (1600) ; et

de suppression de la plaquette de base (1600) en la soumettant à une gravure humide.

**45.** Procédé selon l'une quelconque des revendications 41 à 44, dans lequel du KOH est utilisé dans la gravure humide de ladite plaquette de base (1600).

**46.** Procédé selon l'une quelconque des revendications 40 à 44, comprenant en outre l'étape de suppression de ladite une ou desdites plusieurs couches isolantes (1401) en les soumettant à une gravure humide avec de l'HF.

**47.** Procédé selon l'une quelconque des revendications 40 à 44, dans lequel ladite étape de formation de la couche de dispositif par la fabrication des dispositifs électroniques (1404) sur la couche monocristalline (1402) comprend l'étape d'utilisation d'un procédé de fabrication d'un semi-conducteur.

[Fig. 1]

Preparing a base wafer and a bonding wafer
Forming a nitride film(Si 3N 4) on the base wafer
Forming CVD oxide film on the base wafer
Implanting hydrogen ions into the bonding wafer
Cleaning the base wafer and the bonding wafer
Bonding the base wafer and the bonding wafer
Cleaving the bonding wafer
Fabricating nano SOI by processing the cleaved face
Growing the CVD oxide film on the nano SOI
Forming a nitride film on the CVD oxide film
Removing the base wafer with KOH
Removing the oxide film and the nitride film with HF
Fabricating the flexible single-crystal silicon

[Fig. 2]

(a)
102
101
100
(b)
201
200
(c)
200
201
102
101
100
(d)
(e)
200
202
102
101
100
(f)
202
102
101
100
(g)
301
300
202
102
101
100
(h)
301
300
202
102
101
(i)
300
202
102
(j)
202
(a)
202
203
(b)
202
102


[Fig. 3]

[Fig. 4]
d
100
( a )
R
R=3mm
( b )
202
[Fig. 5]
Providing a SOI wafer
Forming a CVD oxide film
Forming a nitride film
Coating a wax
Bonding the SOI wafer and the supporting wafer
Grinding the base wafer of the SOI wafer
Removing the supporting wafer by removing wax
Removing the base wafer with KOH
Removing the oxide film and the nitride film with HF
Fabricating the flexible single-crystal silicon

[Fig. 6]

(a)
602
601
600
607
(b)
603
602
601
600
(c)
604
603
602
601
600
(d)
605
604
603
602
601
600
(f)
606
605
604
603
602
601
600a
(g)
604
603
602
601
600a
(h)
604
603
602
601
(i)
602

(e)
606
605
604
603
602
601
600

[Fig. 7]

704
705
702
701
703
700
706

[Fig. 8]

800b
(a)
800
801
802
(b)
702
800
801
802
900
(c)
901
(d)
(e)
802

[Fig. 9]

( a )
800
801
802
( b )
702
800
801
802
900
( c )
800
801
802
901
d-1 )
800a
801
802
901
d-2 )
800a
801
802
( e )
800a
801
802
802b

[Fig. 10]

Providing a SOI wafer
Coating a wax
Bonding the SOI wafer and the supporting wafer
Grinding the base wafer of the SOI wafer
Removing the entire base wafer with KOH
Removing the supporting wafer by removing wax
Removing the insulator layer of the SOI wafer with HF
Fabricating the flexible single-crystal silicon

[Fig. 11]

(a)
1002
1001
1000
1007
(b)
1005
1002
1001
1000
(c)
1006
1005
1002
1001
1000
(d)
1006
1005
1002
1001
1000b

[Fig. 12]

(a)
702
1000b
1001
1002
1005
1006
900
(b)
1002
1000b
1001
1002
1005
1006
901
(c)
1001
1002
1005
1006
(d)
1002
1005
1006
(e)
1002

[Fig. 13]

(a)
702
1000b
1001
1002
(b)
900
1000b
1001
1002
(c)
901
1000c
1001
1002
(d)
702
1000c
1001
1002
(e)
1000c
1001
1002
1002
(f)
1002

[Fig. 14]

Providing a SOI wafer
Forming a protective insulator layers
Grinding the base wafer of the SOI wafer
Removing the entire base wafer with KOH
Removing the protective insulator layers with HF
Removing the buried insulator layers with HF
Fabricating the flexible single-crystal silicon

[Fig. 15]

(a)
1202
1201
1207
1200
(b)
1203
1202
1201
1200
(c)
1204
1203
1202
1201
1200
(d)
1204
1203
1202
1201
1200b

[Fig. 16]

[Fig. 17]

(a)
702
1200b
1201
1202
1203
1204
(b)
900
702
1200b
1201
1202
1203
1204
(c)
901
702
1200c
1201
1202
1203
1204
(d)
702
1200c
1201
1202
1203
1204
(e)
702
1200c
1201
1202
1203
1204
1202
1203
1204
(f)
901
1204
1203
1202
(g)
1202
(a)
1402
1401
1406
1400
(b)
1403
1402
1401
1400
(c)
1405
1404
1402
1401
1400
(d)
1405
1404
1402

[Fig. 18]

(a)
1404
1405
1402
(b)
1404
1405
1402
1401

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 0849788 A2
- EP 1069602 A2
- US 10391297 B